# EUROPEAN PATENT SPECIFICATION

(11) **EP 3 561 145 B1**
(45) Date of publication and mention of the grant of the patent: **25.11.2026**
(21) Application number: 17882913.1
(22) Date of filing: 22.12.2017
(51) Int. Cl.: C23C 14/08, C23C 16/40, C23C 4/11, C23C 2/26, C23C 2/06, C25D 5/48, C25D 3/22, C23C 14/58, C23C 14/16, C23C 18/12, C23C 18/16, C23C 20/06, C23C 20/08, C23C 28/00

(54) **ZINC-BASED PLATED STEEL MATERIAL HAVING EXCELLENT SEALER ADHESION AND COMPOSITION FOR FORMING POST-TREATMENT FILM**
ZINKPLATTIERTES STAHLMATERIAL MIT HERVORRAGENDER DICHTSTOFFHAFTUNG UND ZUSAMMENSETZUNG ZUR BILDUNG EINES NACHBEHANDLUNGSFILMS
MATÉRIAU À BASE D'ACIER PLAQUÉ ZINC CARACTÉRISÉ PAR UNE EXCELLENTE ADHÉRENCE DU PRODUIT D'ÉTANCHÉITÉ ET COMPOSITION POUR LA FORMATION D'UN FILM DE POST-TRAITEMENT

(30) Priority: 23.12.2016 KR 20160177331
(43) Date of publication of application: 30.10.2019
(73) Proprietor: POSCO Co., Ltd, Pohang-si, Gyeongsangbuk-do 37859 (KR)
(72) Inventor: KIM, Yeon-Ho, Gwangyang-si Jeollanam-do 57807 (KR); KIM, Yong-Woon, Gwangyang-si Jeollanam-do 57807 (KR); KIM, Yung-Keun, Gwangyang-si Jeollanam-do 57807 (KR); SONG, Yon-Kyun, Gwangyang-si Jeollanam-do 57807 (KR)
(74) Representative: Meissner Bolte Partnerschaft mbB
(86) International application number: PCT/KR2017/015402
(87) International publication number: WO 2018/117759

(56) References cited:
- EP-A1- 2 060 660
- EP-A1- 3 396 011
- JP-A- 2010 047 796
- JP-A- H05 214 559
- JP-A- H1 018 050
- JP-B2- 5 638 191
- KR-B1- 101 103 669
- KR-B1- 101 322 063
- KR-B1- 101 696 115

## Description

### [Technical Field]

The present invention relates to a zinc-based plated steel material having excellent sealer adhesion according to the appended claims.

### [Background Art]

As a zinc-based plated steel sheet used as vehicle panels has an inexpensive price, has excellent corrosion resistance, and implements an excellent surface exterior, an increased amount of zinc-based plated steel sheet has been used for internal and exterior panels of vehicles. The plated steel sheet may go through a press forming process, an assembly process such as a welding process and an adhesion process, a degreasing process, a phosphate process, and a painting process during manufacturing of a vehicle, and properties such as lubricity, weldability, adhesion properties, paintability, and the like, may be required for the zinc-based plated steel sheet.

Zinc-based plated steel sheets may have different properties depending on a composition of a plating layer formed on the steel sheet and a method of manufacturing the same, and deteriorated properties may need to be compensated. For example, in the cases of a hot-dip galvanized steel sheet (GI) and an electrical galvanized steel sheet (EG), there may be the problem in which a plating layer may be separated during a press forming process accompanying high-pressure and high-speed friction due to a ductile plating layer such that the plating layer may be melted and attached onto a bead portion of a die. Accordingly, defects such as scratches or dents may be caused on a surface of the steel sheet. In the case of a hot-dip galvannealed steel sheet (GA), there may be the problem in which a material itself may be broken as lubricity is insufficient during a press forming process due to a high surface friction coefficient or the problem of a powdering phenomenon in which a hard plating layer is separated. For these reasons, improvement of lubricity of the plating steel sheets may be required through a post-treatment, and weldability, adhesion properties, paintability, may need to be satisfied in addition to lubricity.

Also, in the case of a zinc alloy plated steel sheet in which a plating layer includes elements such as aluminum (Al), magnesium (Mg), and the like, although press formability may be excellent, there may be the problem in which adhesion properties with a sealer may degrade during a vehicle body assembly process due to a stable metal oxide present on an outermost surface.

To address such a problem, a post-treatment may be required for a surface of a zinc-based plated steel sheet used as vehicle panels, thereby improving deteriorated properties.

As a technique related to a post-treatment, reference 1 discloses a technique of forming a phosphate layer on a surface of a galvanized layer, and reference 2 discloses a technique of forming a metal oxide layer on a surface of a galvanized layer. However, in the case of the technique of forming a phosphate layer, processes such as a surface adjustment process, a phosphate process, a washing process, a drying process, and the like, may be required, a substantial facility space and solution management may be required in an actual operation, and the technique may be dependent on reaction with a plating layer. Accordingly, a solution composition may need to be changed depending on a type of a zinc-based plated steel sheet, which may be disadvantageous. Also, in the case of the technique of forming a metal oxide layer, as there may be a limitation in a metal composition of a plating layer, there may be the problem in which it may be impossible to apply the technique to all types of zinc-based plated steel sheets.
(Reference 1) Korean Laid-Open Patent Publication No. 10-2001-0074527
(Reference 2) Japanese Laid-Open Patent Publication No. 2014-185381

Patent documents JP H05 214559 A and EP 2 060 660 A1 disclose compositions of post-treatment coatings on Zn-based coated steels to improve lubrication and formability.

### [Disclosure]

### [Technical Problem]

An aspect of the present invention is to provide a zinc-based plated steel material having excellent sealer adhesion.

### [Technical Solution]

The invention is set out in the appended claims.

### [Advantageous Effects]

According to an aspect of the present disclosure, a zinc-based plated steel material including a post-treatment film has an advantage of excellent sealer adhesion.

Also, according to an aspect of the present disclosure, a composition for forming a post-treatment film may be applied to any types of plating layers.

The advantages and effect of the present invention are not limited to those described above, and may be more easily understood in the process of describing specific example embodiments.

### [Best Mode for Invention]

Generally, a zinc-based plated steel material may be used as a steel material for vehicles, and a zinc-based plated steel material may go through a press forming process, an assembly process such as a welding process and an adhesion process, a degreasing process, a phosphate process, and a painting process in order during manufacturing a vehicle. Accordingly, a zinc-based plated steel material used as a steel material for vehicles may be required to have properties such as press workability, weldability, sealer adhesion properties, and the like. If press workability is insufficient, there may be the problem in which a plating layer may be adhered onto a die during a press forming process, or a material may be broken. If weldability is insufficient, contamination may occur in a welding electrode during an assembly process such that an electrode lifespan and the number of consecutive hitting points may decrease. If sealer adhesion properties are insufficient, there may be a problem in strength of an adhesive portion.

For these reasons, generally, to compensate insufficient properties of a zinc-based plated steel material, a post-treatment film may be formed on a zinc-based plated steel material. A post-treatment film may be required to have excellent removing film properties in addition to the above-described properties. That is because, when the removing film properties is insufficient, a post-treatment film may not be sufficiently removed during a degreasing process, and accordingly, defects may occur in a phosphate process and a painting process, subsequent processes, which may consequently degrade paintability.

Considering the background, the inventors of the present disclosure have conducted researches to provide a composition for forming a post-treatment film having excellent press workability, weldability, sealer adhesion properties, and removing film properties, and a zinc-based plated steel material including the post-treatment film formed thereon, and as a result, the present disclosure is suggested.

In the description below, a zinc-based plated steel material having excellent sealer adhesion, an aspect of the present invention, will be described in detail.

The zinc-based plated steel material having excellent sealer adhesion properties includes a base iron, and a zinc-based plated layer and a post-treatment film sequentially formed on the base iron. In the present disclosure, a specific type and shape of a base iron may not be particularly limited, and the base iron may be a hot-rolled steel sheet, a cold-rolled steel sheet, or a steel wire rod. Also, in the present disclosure, a type of a zinc-based plated layer may not be particularly limited, and the zinc-based plated layer may be one of a hot-dip galvanized plated layer, a hot-dip galvannealed plated layer, an electrical galvanized plated layer, and a zinc deposited layer formed by a PVD. Meanwhile, in the present disclosure, types and composition ranges of alloy elements included in the zinc-based plated layer may not be particularly limited. For example, the zinc-based plated layer may include appropriate amounts of elements such as Al, Mg, and Si in addition to Zn.

The post-treatment film includes an oxide or oxide salt of B, and an organic compound, and an oxide or oxide salt of Mo. In the description below, each element composition forming the post-treatment film will be described in detail.

### Oxide or Oxide Salt of Group A Elements

An oxide or oxide salt of group A elements may improve adhesion with a sealer coated on the post-treatment film. The group A elements refers to B.

In the present invention, a content of an oxide or oxide salt of group A elements may not be particularly limited. However, according to an example embodiment, but not limited thereto, 1 mol/kg or higher of the group A elements may be included in the post-treatment film. When a content of the group A elements is less than 1 mol/kg, adhesion strength between the post-treatment film and the sealer may be insufficient, which may be a problem.

In the present invention the group A element is boron (B), an oxide or oxide salt of the group A element may be boracic acid, borax, or the like.

According to the example embodiment, an oxide or oxide salt of group A elements may have at least one or more hydroxyl groups in a solution of pH 4 to 7 range, which may be advantageous to improving sealer adhesion properties of the post-treatment film.

### Oxide or Oxide Salt of Group B Elements

An oxide or oxide salt of group B elements may improve adhesion between the post-treatment film and a material.

Group B element of the present invention refers to Mo.

In the present disclosure, a content of an oxide or oxide salt of group B elements may not be particularly limited. However, according to an example embodiment, but not limited thereto, 3.5 mol/kg or less of group B elements may be included in the post-treatment film. When a content of group B elements exceeds 3.5 mol/kg, a content of group A elements may relatively decrease such that sealer adhesion properties may degrade, and adhesion with a material may increase, such that removing film properties of the post-treatment film may be deteriorated.

In the present disclosure, a specific type of an oxide or oxide salt of group B elements is molybdenum (Mo), an oxide or oxide salt of the group B element may be ammoniummolybdate, sodium phosphomolybdic acid, sodium molybdate, and the like.

### Organic Compound

The organic compound may work as a binder which may allow an oxide or oxide salt in the post-treatment film to be stably present, and may partially improve sealer adhesion properties.

A content of the organic compound may not be particularly limited in the present disclosure. However, according to an example embodiment, but not limited thereto, the organic compound may be included in an amount of 5 parts by weight to 30 parts by weight based on 100 parts by weight of the post-treatment film. When the content is less than 5 parts by weight, film stability or seal adhesion properties may be deteriorated. When the content exceeds 30 parts by weight, the content may be advantageous in terms of seal adhesion properties, but the organic compound itself may work as an adhesive such that the zinc-based plated steel materials in a coil state may be adhered to each other, or worse, the removing of the post-treatment film in a degreasing process during a vehicle assembly process may be insufficient, which may cause defects during a phosphate process and a painting process, subsequent processes.

According to the example embodiment, the organic compound may have at least one or more hydroxyl groups or carboxyl groups. More specifically, the organic compound of the present invention is one or more compounds selected from a group consisting of polyvinyl acetate (PVAc), polyvinyl alcohol (PVA), polyacrylic acid (PAA), polyvinyl butyral (PVB), and polyethylene glycol (PEG), which may be advantageous to improving film stability and sealer adhesion properties.

In the description below, other characteristics of the post-treatment film will be described in detail.

In the zinc-based plated steel material having excellent sealer adhesion properties according to the present invention, a content of oxygen atoms in the post-treatment film may be 50 atom% or higher. When a content of oxygen atoms is less than 50 atom%, an amount of hydroxyl group which may contribute to improving adhesion with a sealer and may work as a bond site may be insufficient, and adhesion strength between the zinc-based plated steel material and a sealer may be deteriorated. A content of oxygen atoms in the post-treatment film may refer to a value observed or calculated only in consideration of elements and oxygen in the post-treatment film, excluding elements of the plating layer and hydrogen, and may be measured using an XPS (X-ray photoelectron spectroscopy) analysis method after removing contamination or rust preventive oil by acetone-degreasing the zinc-based plated steel material including the post-treatment film formed thereon. The reason why the plating layer elements are excluded when calculating an oxygen content is that the composition for forming the post-treatment film of the present disclosure may rarely react with the plating layer, and if the composition for forming the post-treatment film reacts with the plating layer and the elements of the plating layer affect the composition of the post-treatment film, it may be required to calculate the oxygen content in consideration of contents of elements of the plating layer. Meanwhile, a more preferable content of oxygen atoms in the composition for forming the film may be 55 atoms% or higher, and an even more preferable content may be 60 atoms% or higher.

Also, the zinc-based plated steel material having excellent sealer adhesion according to the present invention is characterized in that, when a mole number of oxygen atoms forming a covalent bond with hydrogen in the post-treatment film is a, and a mole number of oxygen atoms which do not form a covalent bond with hydrogen is b, a/b may be 0.3 or more. When a/b is less than 0.3, an amount of hydroxyl group which may contribute to improving adhesion with a sealer and may work as a bond site may be insufficient such that adhesion strength between the zinc-based plated steel material and a sealer may be deteriorated. The greater the value of a/b, it may be more advantageous to improving sealer adhesion properties, and thus, in the present disclosure, an upper limit thereof may not be particularly limited. However, when the value is excessively high, the value may be disadvantageous in terms of adhesion with a material and film stability, and thus, considering this, an upper limit thereof may be limited to 10. a/b may be obtained through curve filling of a binding energy peak of oxygen measured using an XPS (X-ray photoelectron spectroscopy) analysis method after removing contamination or rust preventive oil by acetone-degreasing the zinc-based plated steel material including the post-treatment film formed thereon. A more preferable range of a/b may be 1.0 or more and 9.0 or less, and an even more preferable range of a/b may be 2.0 or more and 8.0 or less.

According to the example inventive embodiment, in the case in which the post-treatment film of the zinc-based plated steel material having excellent sealer adhesion properties of the present disclosure includes an oxide or oxide salt of group B elements, when a mole number of the group A elements having at least one or more hydroxyl groups in a solution of pH 4 to 7 range is c, and a mole number of the group B elements is d, c/d may be 0.5 or more, which may be advantageous to improving sealer adhesion properties of the post-treatment film. The greater the value of c/d, it may be more advantageous to improving sealer adhesion properties, and thus, in the present disclosure, an upper limit thereof may not be particularly limited. However, when the value is excessively high, the value may be disadvantageous in terms of adhesion with a material and film stability, and thus, considering this, an upper limit thereof may be limited to 100. A more preferable range of c/d may be 2.0 or more and 50 or less, and an even more preferable range may be 5.0 or more and 30 or less.

A specific method of forming the post-treatment film may not be particularly limited. However, according to an example embodiment, but not limited thereto, the post-treatment film may be formed by a dry coating method such as a PVD (physical vapor deposition) and a CVD (chemical vapor deposition), a powder spraying coating method such as a thermal spray coating, a solution coating method such as a roll coating process, and the like. When the post-treatment film is formed by a solution coating method, a process may be simplified, and costs of operating the process may be lowered, which may be advantageous.

However, when the post-treatment film is formed by a solution coating method, it may be required to control a drying temperature to be lower than 150°C during drying after coating. When the drying temperature is 150°C or higher, a/b of the post-treatment film may decrease as compared to a/b of the composition for forming a post-treatment film such that it may be difficult to achieve the purpose of improving sealer adhesion properties.

In the present invention an amount of attached film of the post-treatment film is 100mg/m² to 1000mg/m². When the amount of attached film is less than 100mg/m², due to roughness of a material itself, the post-treatment film may not be uniformly formed. When the amount of attached film exceeds 1000mg/m², manufacturing costs may increase, and a drying process may be insufficiently performed.

In the description below, a composition for forming a post-treatment film having excellent sealer adhesion, another aspect of the present disclosure, will be described in detail.

The composition for forming a post-treatment film may include an oxide or oxide salt of one or more group A elements selected from a group consisting of B, Al, V, and Fe, and an organic compound. As described above, if desired, the composition for forming a post-treatment film may include an oxide or oxide salt of one or more group B elements selected from a group consisting of Mn, Mo, and W. The reason why the post-treatment film may include the above-mentioned elements is as described in the aforementioned example embodiment. Meanwhile, in the present disclosure, other effective elements besides the above-described elements may not be excluded. For example, a leveling agent, and the like, may further be included.

The composition for forming a post-treatment film may be provided as a solution form in which the elements described below are dissolved into a solvent such as water, or may be provided as a power form in which the elements described below are mixed. When the composition for forming the post-treatment film is provided as a solution form, a content of each element described below, a content of oxygen atoms, a ratio of a mole number of oxygen atoms, and the like, may be values measured with reference to a non-volatile solid excluding a solvent such as water.

In the composition for forming the post-treatment film, a content of oxygen atoms may be 50 atom% or higher. The reason why a content of oxygen atoms in the composition for forming the post-treatment film is controlled as above is as described in the aforementioned example embodiment. A content of oxygen atoms in the composition for forming the post-treatment film may be calculated from a molecular structure of specific elements constituting the composition for forming the post-treatment film.

Also, in the composition for forming the post-treatment film, when a mole number of oxygen atoms forming a covalent bond with hydrogen is a, and a mole number of oxygen atoms which do not form a covalent bond with hydrogen is b, a/b is 0.3 or more. The reason why a/b is controlled as above is as described in the aforementioned example embodiment. a/b may be calculated from a molecular structure of specific elements constituting the composition for forming the post-treatment film.

In the present disclosure, pH of the composition for forming the post-treatment film may not be particularly limited, but to prevent dissolution of the plating layer and to form a stable film, a preferable pH may be 3.0 to 7.0.

### [Mode for Invention]

In the description below, an embodiment of the present invention will be described in detail. The below embodiment is provided for understanding of the present invention, and will not limit the present disclosure. The scope of the invention is defined by the appended claims.

### (Embodiment)

A zinc-based plated steel sheet having a thickness of 0.8mm, an elongation rate of 36 to 37%, an amount of plating of 35g/m², and having a plating layer including 1.4% of Al, 1.4% of Mg, and 97.2% of Zn was prepared, the zinc-based plated steel sheet was coated with a post-treatment coating solution by a bar-coating method, and a post-treatment film was formed with an amount of coating of 300mg/m² under a condition of PMT of 100°C. In each sample, a post-treatment film was manufactured while differentiating only contents of elements included in a composition for forming the post-treatment film, and a content of each element included in the manufactured post-treatment film was listed in Table 1 below. A conventional example in Table 1 below refers to an example in which the post-treatment film was not formed.

A content of oxygen in the post-treatment film and a/b were measured, and the results were listed in Table 1 as well. A content of oxygen in the post-treatment film is an average value of each unit depth of a nanometer scale, obtained by measuring the zinc-based plated steel material including the post-treatment film formed thereon using an XPS(X-ray Photoelectron Spectroscopy) analysis method, and a/b is an average value of each unit depth obtained through curve fitting of an oxygen(O) binding energy peak measured using an XPS analysis method.

Workability, sealer adhesion properties, and removing film properties of each sample were tested, and the results were listed in Table 1 as well.

### <Workability Test>

To test workability, a cup drawing test was performed, and in the cup drawing test, a testing device including a die and a punch was used. The test was performed while increasing BHF(Blank Holding Force), and a BHF value right before breakage of a material occurred was determined as a maximum BHF value, and was listed in Table 1. The higher the maximum BHF value, the more excellent the workability may be, and specific conditions of the cup drawing test conducted in the present disclosure were as below.

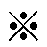 Specific Conditions of Cup Drawing Test

- Punch diameter: 50mm
- Punch edge radius: 6mm
- Die diameter: 52.25mm
- Punch moving speed : 230mm/min
- The post-treatment film was in contact with the die, and the test was performed after coating a surface with washing oil.

### <Sealer Adhesion Properties Test>

In the adhesion test, two samples of a size of 25mmX100mm were manufactured, washing oil was coated, the samples were stood up vertically and maintained for one day, a mastic sealer adhesive was coated at a position of 10mm from edges of the sample in a size of 25mm (width) X25mm (length) X3mm (height), the other sample was piled on the sample and cured at 170°C for 20 minutes, adhesion shear strength of each of the upper/lower samples was measured, and the results were listed in Table 1. The shear strength was measure at a speed of 50mm/min, and the measured maximum force was divided by an adhesion area of 6.25cm², and the result was listed. As for whether sealer adhesion properties was good or not, when a value is greater than 1.0 kgf/cm², a reference value, sealer adhesion properties was determined as good.

### <Removing Film Properties Test>

In the removing film properties test, a material was stirred and submerged using a degreasing solution used in a vehicle manufacturing process at 50 to 55°C for two minutes and was washed, an amount of coated film remaining on a surface of the material was measured, and a removing film rate based on an amount of coated film before degreasing was calculated by percentage and listed in Table 1. As for a residual amount of a coated film, a certain area of the coated layer was dissolved using an acid solution, a content of molybdenum of the dissolving solution was quantitative-analyzed using an ICP (inductively coupled plasma), and an amount of residue in each area was calculated.

**[Table 1]**

| Classifica tion | Post-Treatment Film Composition | | | | | | | Properties Test Result | | |
|---|---|---|---|---|---|---|---|---|---|---|
| | Mo Acid Salt Compo und (wt%) | Boron Compou nd (wt%) | PEG (wt%) | Other Addit ives (wt%) | Conten t of Oxygen in Film (Atom% ) | a/b | c/d | Maxim um BHF (ton) | Adhes ion Stren gth (kgf/ cm²) | Remov ing Film Rate (%) |
| Convention al Example | - | - | - | | - | - | - | 6 | 0.4 | - |
| Comparativ e Example 1 | 76.90 | 0.00 | 18.08 | 5.02 | 48.23 | 0.01 | 0.00 | 12 | 0.8 | 93 |
| Comparativ e Example 2 | 70.41 | 6.12 | 18.37 | 5.10 | 51.84 | 0.17 | 0.28 | 11 | 0.9 | 96 |
| Inventive | 66.67 | 10.78 | 17.65 | 4.90 | 53.51 | 0.31 | 0.51 | 10 | 1.3 | 95 |
| Example 1 | | | | | | | | | | |
| Inventive Example 2 | 49.77 | 20.93 | 22.93 | 6.37 | 54.54 | 0.68 | 1.33 | 11 | 2.1 | 93 |
| Inventive Example 3 | 41.32 | 32.00 | 20.88 | 5.80 | 57.91 | 1.21 | 2.45 | 9 | 4.2 | 93 |
| Inventive Example 4 | 39.77 | 34.009 | 20.45 | 5.68 | 58.52 | 1.33 | 2.72 | 13 | 4.5 | 94 |
| Inventive Example 5 | 28.09 | 46.48 | 19.90 | 5.53 | 61.26 | 2.25 | 5.24 | 14 | 5.0 | 93 |
| Inventive Example 6 | 20.10 | 57.01 | 17.91 | 4.98 | 63.79 | 3.46 | 8.99 | 10 | 5.0 | 95 |
| Inventive Example 7 | 16.13 | 63.04 | 16.30 | 4.53 | 65.29 | 4.47 | 12.38 | 13 | 5.1 | 95 |
| Inventive Example 8 | 13.45 | 65.36 | 16.58 | 4.61 | 65.57 | 4.98 | 15.40 | 10 | 5.2 | 96 |
| Inventive Example 9 | 7.90 | 72.90 | 15.03 | 4.18 | 67.16 | 7.21 | 29.24 | 12 | 5.1 | 97 |
| Inventive Example 10 | 2.63 | 77.19 | 15.79 | 4.39 | 67.54 | 9.37 | 92.94 | 11 | 4.8 | 97 |
| Example 11 | 0.89 | 78.57 | 16.07 | 4.46 | 67.65 | 10.2 8 | 278.8 3 | 13 | 4.8 | 99 |
| Example 12 | 0.00 | 80.23 | 15.48 | 4.30 | 68.05 | 11.4 6 | - | 11 | 4.3 | 98 |

Referring to Table 1, as for conventional example and comparative examples 1 and 2 in which a content of oxygen (O) was lower than 50 atom% or a/b was less than 0.3, adhesion strength was less than 1.0 kgf/cm² such that a sealer adhesion properties reference was not satisfied.

Differently from the comparative examples, as for inventive examples 1 to 12 in which a content of oxygen (O) was 50 atom% or greater and a/b was 0.3 or more, adhesion strength sufficiently satisfied 1.0 kgf/cm² or more, an adhesion strength reference. Particularly, the higher the content of oxygen (O) in the film and a/b, the higher the adhesion strength was. However, as for inventive examples 11 and 12, a film composition during drying after coating was not uniform such that stains were created.

Although an adhesion strength reference was 1.0kgf/cm², considering a cohesion breakage rate of a broken surface of an adhesion portion after testing shear strength, and to secure more solid adhesion strength, a preferable content of oxygen (O) included in the post-treatment film may be 55 atom% or higher, and a/b may be 1.0 or more more preferably.

A maximum BHF value and removing film properties were excellent in overall post-treatment film conditions regardless of a content of oxygen in the film or a/b. Particularly, maximum BHF values of comparative examples 1 and 2 and inventive examples 1 to 12 in which the post-treatment film was formed were higher than that of the conventional example, a non-treatment material, which indicates that workability may significantly improve when the post-treatment film is formed.

Meanwhile, in the present disclosure, a/b in the film was controlled using a large amount of oxide or oxide salt and a small amount of an organic compound, but the present disclosure is not limited thereto. In addition to the method described above, a/b in the film may also be controlled using a ratio between oxygen and hydroxyl group present in a molecular structure of the organic compound formed in 30 weight% or lower in the film.

While the exemplary embodiments have been shown and described above, it will be apparent to those skilled in the art that modifications and variations could be made without departing from the scope of the present invention as defined by the appended claims.

## Claims

1. A zinc-based plated steel material, comprising:
a base iron, and a zinc-based plated layer and a post-treatment film sequentially formed on the base iron;
wherein the post-treatment film comprises an oxide or oxide salt of B, and an organic compound and further comprises an oxide or oxide salt of Mo,
wherein a content of oxygen atoms in the post-treatment film is 50 atom% or higher, and
wherein, when a mole number of oxygen atoms forming a covalent bond with hydrogen in the post-treatment film is a, and a mole number of oxygen atoms which do not form a covalent bond with hydrogen is b, a/b is 0.3 or more and 10 or less
wherein when a mole number of B is c, and a mole number of Mo is d, c/d is 0.5 or more and 100 or less,
wherein the organic compound is one or more compounds selected from a group consisting of polyvinyl acetate (PVAc), polyvinyl alcohol (PVA), polyacrylic acid (PAA), polyvinyl butyral (PVB), and polyethylene glycol (PEG),
wherein an amount of coated film of the post-treatment film is 100mg/m² to 1000mg/m², the parameters of the content of oxygen atoms and the mole number of oxygen atoms are measured with the respective methods disclosed in the description.

2. The zinc-based plated steel material of claim 1, wherein a content of oxygen atoms in the post-treatment film is 55 atom% or higher.

3. The zinc-based plated steel material of claim 1, wherein a/b is 1.0 or more and 9.0 or less.

4. The zinc-based plated steel material of claim 1, wherein a/b is 2.0 or more and 8.0 or less.

5. The zinc-based plated steel material of claim 1, wherein c/d is 2.0 or more and 50 or less.

6. The zinc-based plated steel material of claim 1, wherein c/d is 5.0 or more and 30 or less.

7. The zinc-based plated steel material of claim 1, wherein the organic compound is included in an amount of 5 parts by weight to 30 parts by weight based on 100 parts by weight of the post-treatment film.

8. The zinc-based plated steel material of claim 1, wherein the organic compound has at least one or more hydroxyl groups or carboxyl groups.

9. The zinc-based plated steel material of claim 1, wherein an oxide or oxide salt of B has at least one or more hydroxyl groups in a solution of pH 4 to 7 range.

## Patentansprüche

1. Zinkplattiertes Stahlmaterial, umfassend:
ein Basiseisen und eine zinkplattierte Schicht und einen Nachbehandlungsfilm, die nacheinander auf dem Basiseisen gebildet sind;
wobei der Nachbehandlungsfilm ein Oxid oder Oxidsalz von B und eine organische Verbindung umfasst und ferner ein Oxid oder Oxidsalz von Mo umfasst,
wobei ein Gehalt an Sauerstoffatomen in dem Nachbehandlungsfilm 50 Atom-% oder höher beträgt und
wobei, wenn eine Molzahl von Sauerstoffatomen, die in dem Nachbehandlungsfilm eine kovalente Bindung mit Wasserstoff bilden, a ist und eine Molzahl von Sauerstoffatomen, die keine kovalente Bindung mit Wasserstoff bilden, b ist, a/b 0,3 oder mehr und 10 oder weniger beträgt,
wobei, wenn eine Molzahl von B c ist und eine Molzahl von Mo d ist, c/d 0,5 oder mehr und 100 oder weniger beträgt,
wobei es sich bei der organischen Verbindung um eine oder mehrere Verbindungen handelt, die ausgewählt sind aus einer Gruppe bestehend aus Polyvinylacetat (PVAc), Polyvinylalkohol (PVA), Polyacrylsäure (PAA), Polyvinylbutyral (PVB) und Polyethylenglycol (PEG),
wobei eine Menge an beschichtetem Film des Nachbehandlungsfilms 100 mg/m² bis 1000 mg/m² beträgt, wobei die Parameter des Gehalts an Sauerstoffatomen und der Molzahl von Sauerstoffatomen mit den jeweiligen in der Beschreibung offenbarten Verfahren gemessen werden.

2. Zinkplattiertes Stahlmaterial nach Anspruch 1, wobei ein Gehalt an Sauerstoffatomen in dem Nachbehandlungsfilm 55 Atom-% oder höher beträgt.

3. Zinkplattiertes Stahlmaterial nach Anspruch 1, wobei a/b 1,0 oder mehr und 9,0 oder weniger beträgt.

4. Zinkplattiertes Stahlmaterial nach Anspruch 1, wobei a/b 2,0 oder mehr und 8,0 oder weniger beträgt.

5. Zinkplattiertes Stahlmaterial nach Anspruch 1, wobei c/d 2,0 oder mehr und 50 oder weniger beträgt.

6. Zinkplattiertes Stahlmaterial nach Anspruch 1, wobei c/d 5,0 oder mehr und 30 oder weniger beträgt.

7. Zinkplattiertes Stahlmaterial nach Anspruch 1, wobei die organische Verbindung in einer Menge von 5 Gewichtsteilen bis 30 Gewichtsteilen auf Grundlage von 100 Gewichtsteilen des Nachbehandlungsfilms beinhaltet ist.

8. Zinkplattiertes Stahlmaterial nach Anspruch 1, wobei die organische Verbindung mindestens eine oder mehrere Hydroxylgruppen oder Carboxylgruppen aufweist.

9. Zinkplattiertes Stahlmaterial nach Anspruch 1, wobei ein Oxid oder Oxidsalz von B mindestens eine oder mehrere Hydroxylgruppen in einer Lösung mit einem pH-Wert im Bereich von 4 bis 7 aufweist.

## Revendications

1. Matériau en acier plaqué à base de zinc, comprenant :
un fer de base, et une couche plaquée à base de zinc et un film de post-traitement formés successivement sur le fer de base ;
dans lequel le film de post-traitement comprend un oxyde ou un sel d'oxyde de B, et un composé organique, et comprend en outre un oxyde ou un sel d'oxyde de Mo,
dans lequel la teneur en atomes d'oxygène dans le film de post-traitement est de 50 % atomique ou plus, et
dans lequel, lorsqu'un nombre de moles d'atomes d'oxygène formant une liaison covalente avec l'hydrogène dans le film de post-traitement est a, et qu'un nombre de moles d'atomes d'oxygène qui ne forment pas de liaison covalente avec l'hydrogène est b, a/b vaut 0,3 ou plus et 10 ou moins,
dans lequel, lorsqu'un nombre de moles de B est c, et qu'un nombre de moles de Mo est d, c/d vaut 0,5 ou plus et 100 ou moins,
dans lequel le composé organique est un ou plusieurs composés choisis dans un groupe consistant en le polyacétate de vinyle (PVAc), l'alcool polyvinylique (PVA), l'acide polyacrylique (PAA), le polybutyral de vinyle (PVB) et le polyéthylène glycol (PEG),
dans lequel une quantité de dépôt de film de revêtement du film de post-traitement est de 100 mg/m² à 1 000 mg/m², les paramètres de la teneur en atomes d'oxygène et du nombre de moles d'atomes d'oxygène sont mesurés à l'aide des procédés respectifs divulgués dans la description.

2. Matériau en acier plaqué à base de zinc selon la revendication 1, dans lequel une teneur en atomes d'oxygène du film de post-traitement est de 55 % atomique ou plus.

3. Matériau en acier plaqué à base de zinc selon la revendication 1, dans lequel a/b vaut 1,0 ou plus et 9,0 ou moins.

4. Matériau en acier plaqué à base de zinc selon la revendication 1, dans lequel a/b vaut 2,0 ou plus et 8,0 ou moins.

5. Matériau en acier plaqué à base de zinc selon la revendication 1, dans lequel c/d vaut 2,0 ou plus et 50 ou moins.

6. Matériau en acier plaqué à base de zinc selon la revendication 1, dans lequel c/d vaut 5,0 ou plus et 30 ou moins.

7. Matériau en acier plaqué à base de zinc selon la revendication 1, dans lequel le composé organique est inclus en une quantité de 5 parties en poids à 30 parties en poids par rapport à 100 parties en poids du film de post-traitement.

8. Matériau en acier plaqué à base de zinc selon la revendication 1, dans lequel le composé organique comporte au moins un ou plusieurs groupes hydroxyle ou groupes carboxyle.

9. Matériau en acier plaqué à base de zinc selon la revendication 1, dans lequel un oxyde ou un sel d'oxyde de B comporte au moins un ou plusieurs groupes hydroxyle dans une solution ayant une plage de pH 4 à 7.
